# EUROPEAN PATENT APPLICATION

(11) **EP 2 311 915 A1**
(43) Date of publication of application: **20.04.2011**
(21) Application number: 09773335.6
(22) Date of filing: 22.06.2009
(51) Int. Cl.: C08L 101/02, C08G 18/61, C08G 18/83, C08K 5/00, C08L 83/04, H01B 3/30, H01L 21/312

(54) **COMPOSITION FOR INSULATING LAYER**

(30) Priority: 30.06.2008 JP 2008171155
(71) Applicant: Sumitomo Chemical Company, Limited, Tokyo 104-8260 (JP)
(72) Inventor: YAHAGI Isao, Tsuchiura-shi Ibaraki 300-0848 (JP)
(74) Representative: Duckworth, Timothy John
(86) International application number: PCT/JP2009/061326
(87) International publication number: WO 2010/001757

(57) **Abstract**

An object of the present invention is to provide a composition for an insulating layer, which can form the insulating layer (for instance, a gate insulating film and a protective layer of a transistor) at a low temperature, and further can form the insulating layer having superior withstand voltage. The composition for an insulating layer according to the present invention includes a first compound formed of a polymer compound having two or more active hydrogen groups in the molecule, and a second compound formed of a low-molecular compound having, in the molecule, two or more groups that produce a functional group which reacts with an active hydrogen group by electromagnetic radiations or heat.

## Description

### Technical Field

The present invention relates to a composition for an insulating layer, and particularly to a composition for forming an insulating layer in a transistor and the like.

### Background Art

A plastic substrate of polycarbonate, polyethylene terephthalate and the like has been investigated as a substrate of a flexible display device such as an electronic paper. However, these plastic substrates have the problem of causing slight extension and shrinkage during being heated, and accordingly have been required to have higher heat resistance. On the other hand, an organic thin film transistor has received attention as a transistor to be mounted on the above-described substrate of the device, because of being a thin type and superior in flexibility. Because the plastic substrate has not had sufficient heat resistance as was described above, a process of manufacturing an organic thin film transistor on a substrate can be preferably conducted at as low a temperature as possible.

In a process of manufacturing an organic thin film transistor, generally, a high temperature is required particularly for a process of forming and curing a gate insulating film which is an insulating layer provided between a gate electrode and an organic semiconductor layer, and an insulating protective layer which is provided on the top part for protecting the organic thin film transistor. Accordingly, in order to conduct the process of manufacturing the organic thin film transistor at a low temperature, it is important to conduct a step of forming these layers at a low temperature.

A method of anodizing the surface of a gate electrode (see Patent Literature 1), a method of forming the film with a chemical vapor deposition method (see Patent Literature 2) and the like, for instance, are known as the method for forming the gate insulating film at a low temperature. However, in these methods, the process of forming the gate insulating film is complicated.

For this reason, it is investigated as means for simply forming the gate insulating film at a low temperature to form the film with the means of application or the like. For instance, the following Non Patent Literature 1 describes a method of forming the gate insulating film by spin-coating poly(4-vinylphenol) or poly(melamine-formaldehyde), and curing the compound at 200°C.

### Citation List

### Patent Literature

Patent Literature 1: Japanese Patent Application Laid-Open Publication No. 2003-258260
Patent Literature 2: Japanese Patent Application Laid-Open Publication No. 2004-72049

### Non Patent Literature

Non Patent Literature 1: Hagen Klauk et al., J. Appl. Phys., Vol. 92., No. 9., p. 5259-5263 (2002)

### Summary of Invention

### Technical Problem

In the case of the above-described method described in Non patent Literature 1, it has been necessary for forming the gate insulating film to cure the material at a high temperature. However, there are many cases in which it is not possible to sufficiently suppress the expansion and contraction of a plastic substrate due to heat at such a temperature necessary for curing, and for instance, when producing a display device having fine pixels, it becomes impossible to neglect the influence. Accordingly, in recent years, it has been demanded to be capable of forming the gate insulating film at a lower temperature.

In addition, it is required for a gate insulating film or a protective layer of the above described organic thin film transistor not to easily cause the breakdown by a voltage to be applied, in other words, to have a high withstand voltage. However, it has been still difficult that these layers have both characteristics of being capable of being formed at a low temperature and having the high withstand voltage.

For this reason, the present invention have been made in view of such circumstances, and an object thereof is to provide a composition for an insulating layer, which can form the insulating layer (for instance, a gate insulating film and a protective layer of a transistor) at a low temperature, and further can form the insulating layer having superior withstand voltage.

### Solution to Problem

In order to attain the above described object, a composition for an insulating layer according to the present invention includes a first compound formed of a polymer compound having two or more active hydrogen groups in the molecule, and a second compound formed of a low-molecular compound having, in the molecule, two or more groups (hereinafter, referred to as " dissociable groups") that produce a functional group (hereinafter, referred to as a "reactive functional group") which reacts with an active hydrogen group by electromagnetic radiations or heat.

The composition for an insulating layer according to the present invention having such a structure produces the reactive functional group from the dissociable group by the application of the electromagnetic radiations or heat to the second compound, and subsequently causes a reaction between the reactive functional group and the active hydrogen group in the first compound to progress curing. Here, the second compound can easily produce the reactive functional group by the electromagnetic radiations or the heat, and the thereby produced reactive functional group can also easily react with the active hydrogen groups in the first compound. Accordingly, the composition for an insulating layer according to the present invention can be cured by the irradiation of the electromagnetic radiations or being heated at a relatively low temperature, and does not need a high temperature which has been conventionally needed when the insulating layer (the gate insulating film or the protective layer) is formed. Accordingly, the above described composition for an insulating layer according to the present invention can adequately form the insulating layer even at a low temperature.

In addition, in the composition for an insulating layer according to the present invention, after the reactive functional group has been produced in the second compound by the electromagnetic radiations or the heat, the reactive functional group can easily react with the active hydrogen groups included in the first compound, and as a result, the obtained cured material results in having a dense structure in which the first compound and the second compound are adequately bonded. Therefore, the composition for an insulating layer according to the present invention can form the insulating layer having the superior insulating properties and further having the high withstand voltage, even when the insulating layer has been cured at a relatively low temperature.

In the above described composition for an insulating layer according to the present invention, the first compound is preferably formed of a polymer compound having at least one group selected from the group consisting of a phenolic hydroxyl group, an alcoholic hydroxyl group, an amino group, a mercapto group and a carboxyl group, as the active hydrogen group. These active hydrogen groups can cause an adequate reaction with the reactive functional group produced in the second compound.

The first compound, in particular, is preferably a polyorganosilsesquioxane resin having an active hydrogen group, and more preferably a polyorganosilsesquioxane resin having at least one group among groups represented by the following formula (1) and groups represented by the following formula (2). By using these polyorganosilsesquioxane resins, such effects are obtained that the resins can be easily dissolved in an alcoholic solvent and are superior in handlability and the like. 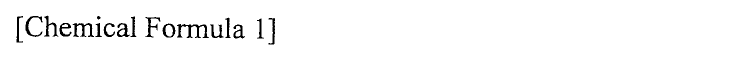 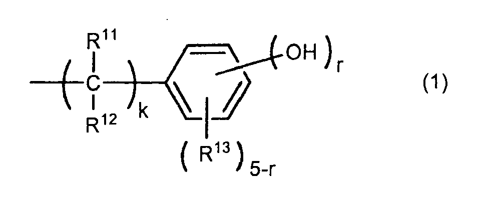 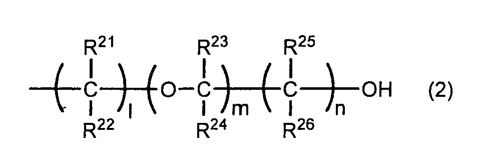 wherein R¹¹ and R¹² each independently represent a hydrogen atom or a monovalent organic group having 1 to 20 carbon atoms, R¹³ represents a hydrogen atom or a monovalent organic group having 1 to 20 carbon atoms, r is an integer of 1 to 5, and k is an integer of 0 or more, wherein when there are a plurality of R¹³, these may be the same or different; and R²¹, R²², R²³, R²⁴, R²⁵ and R²⁶ each independently represent a hydrogen atom or a monovalent organic group having 1 to 20 carbon atoms, 1 and m are each independently an integer of 0 or more, and n is an integer of 1 or more.

In addition, in the composition for an insulating layer of the present invention, a group (dissociable group) that produces the functional group which reacts with an active hydrogen group by electromagnetic radiations or heat in the second compound preferably includes a blocked isocyanato group or a blocked isothiocyanato group. These blocked groups can easily produce an isocyanato group or an isothiocyanato group which are reactive functional groups, by the electromagnetic radiations or heat applied thereto, and accordingly can form the insulating layer at a lower temperature.

Such a blocked isocyanato group or a blocked isothiocyanato group preferably includes a group represented by the following formula (3 a) or a group represented by the following formula (3b): 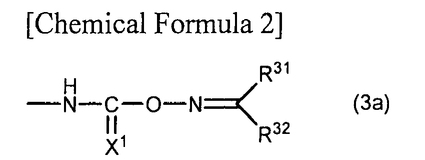 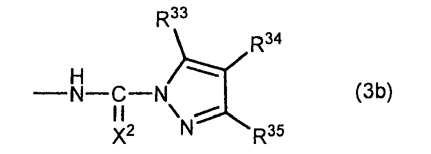 wherein X¹ and X² each independently represent an oxygen atom or a sulfur atom, and R³¹, R³², R³³, R³⁴ and R³⁵ each independently represent a hydrogen atom or a monovalent organic group having 1 to 20 carbon atoms.

More specifically, the second compound is preferably at least one compound out of compounds represented by the following formula (4a) and compounds represented by the following formula (4b). By applying such a second compound, the composition for an insulating layer becomes much more advantageous to the curing at a low temperature, and besides, more superior withstand voltage can be obtained. 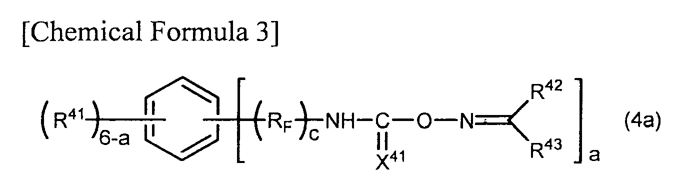 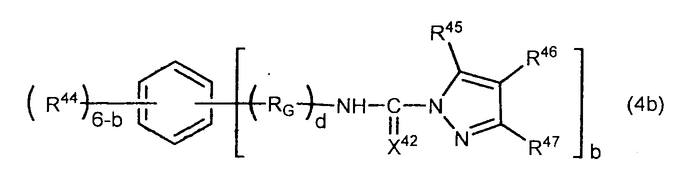 wherein X⁴¹ and X⁴² each independently represent an oxygen atom or a sulfur atom, R⁴¹, R⁴², R⁴³, R⁴⁴, R⁴⁵, R⁴⁶ and R⁴⁷ each independently represent a hydrogen atom or a monovalent organic group having 1 to 20 carbon atoms, R_{F} and R_{G} each independently represent a divalent organic group having 1 to 20 carbon atoms, a and b are each independently an integer of 2 to 6, and c and d are each independently an integer of 0 to 20.

### Advantageous Effects of Invention

The present invention can provide a composition for an insulating layer, which can form the insulating layer (for instance, a gate insulating film and a protective layer of a transistor) at a low temperature, and further can form the insulating layer having superior withstand voltage.

### Brief Description of Drawings

[Figure 1] Figure 1 is a view schematically illustrating a sectional structure of an organic thin film transistor according to a first embodiment;
[Figure 2] Figure 2 is a view schematically illustrating a sectional structure of an organic thin film transistor according to a second embodiment; and
[Figure 3] Figure 3 is a view schematically illustrating a sectional structure of a display according to a preferred embodiment.

### Description of Embodiments

Preferred embodiments according to the present invention will be described below with reference to the drawings, as needed. For information, in the description of the drawings, the same reference numerals will be put on the same elements and overlapping descriptions will be omitted.

### [Composition for insulating layer]

Firstly, a composition for an insulating layer according to a preferred embodiment will be described below.

The composition for an insulating layer according to the present embodiment contains a first compound formed of a polymer compound having two or more active hydrogen groups in the molecule, and a second compound formed of a low-molecular compound having, in the molecule, two or more groups (dissociable groups) that produce a functional group (reactive functional group) which reacts with an active hydrogen group by electromagnetic radiations or heat.

In addition, in the present specification, a "polymer compound" means a compound having a structure in which the same structural unit repeats several times in the molecule, and includes a so-called dimer as well. On the other hand, a "low-molecular compound" means a compound in which the same structural unit does not repeat in the molecule.

(First Compound) Firstly, the first compound will be described below.

The first compound is a polymer compound having two or more active hydrogen groups in the molecule. In this first compound, the active hydrogen group includes an amino group, a hydroxyl group or a mercapto group. Among them, the active hydrogen group is preferably the hydroxyl group that can adequately react with the reactive functional group (particularly, an isocyanato group or an isothiocyanato group) which will be described later.

In the first compound, the active hydrogen group may be directly bonded to a main chain constituting the polymer compound, or may also be bonded to the main chain through a predetermined group. In addition, the active hydrogen group may also be contained in the structure unit constituting the polymer compound, and in this case, the active hydrogen group may be contained in each of the structure units or may also be contained in only some of the structure units. Furthermore, the active hydrogen group may also be bonded to only a terminal end of the polymer compound.

Such a first compound can be obtained, for instance, by solely condensing or polymerizing a monomer compound (monomer) which has the active hydrogen group and can be condensed and polymerized, or copolymerizing the monomer compound with another copolymerizable compound. In addition, when producing the compounds, it is also acceptable to use a monomer compound having the active hydrogen group in such a state that the active hydrogen group is protected in a predetermined form, and produce the active hydrogen group by eliminating the protection after having condensed or polymerized the monomer.

The first compound is firstly preferably a polyorganosilsesquioxane resin having two or more active hydrogen groups. This polyorganosilsesquioxane resin can be obtained by hydrolyzing and condensing an organoalkoxysilane having the active hydrogen group or a protected active hydrogen group, in the presence of an acid catalyst or an alkali catalyst and water, and by eliminating the protection for the active hydrogen group, as needed. In addition, the active hydrogen group may also be added to the resin after the hydrolysis condensation.

Among the polyorganosilsesquioxane resins having the active hydrogen group, a polyorganosilsesquioxane resin having two or more hydroxyl groups is preferable. Such a polyorganosilsesquioxane resin can be obtained, for instance, by hydrolyzing and condensing an organoalkoxysilane in the presence of an acid catalyst or an alkali catalyst and water, subsequently sealing the hydroxyl group in a silanol group existing at both ends of this hydrolysis condensate with a chlorosilane compound, and then eliminating the protection for the hydroxyl group, as needed. In addition, the resin can be obtained also by previously hydrolyzing and condensing an organoalkoxysilane having a hydroxyl group or a protected hydroxyl group, and then eliminating the protection, as needed. The acid catalyst to be used for the hydrolysis condensation of the organoalkoxysilane includes, for instance, hydrochloric acid and acetic acid. In addition, the alkali catalyst includes, for instance, ammonia and triethyl amine.

The organoalkoxysilane which is a raw material of the polyorganosilsesquioxane resin includes organoethoxysilane and organomethoxysilane. More specifically, the organoalkoxysilane includes tetraethoxysilane, tetramethoxysilane, methyl triethoxysilane, methyl trimethoxysilane, dimethyl diethoxysilane, dimethyl dimethoxysilane, trimethyl ethoxysilane, trimethyl methoxysilane, ethyl triethoxysilane, ethyl trimethoxysilane, diethyl diethoxysilane, diethyl dimethoxysilane, triethyl ethoxysilane, triethyl methoxysilane, phenyltriethoxysilane, phenyltrimethoxysilane, diphenyl diethoxysilane, diphenyl dimethoxysilane, triphenyl ethoxysilane, triphenyl methoxysilane, methyl phenyl diethoxysilane, methyl phenyl dimethoxysilane, dimethyl phenyl ethoxysilane and dimethyl phenyl methoxysilane.

The chlorosilane having the protected hydroxyl group to be reacted with the hydrolysis condensate of the organoalkoxysilane includes a chlorosilane obtained by making a compound having the protected hydroxyl group and an unsaturated bond such as a vinyl group and an allyl group in the molecule react with a dialkyl chlorohydrosilane compound in the presence of a transition metal catalyst to form a hydrosilylated compound. The chlorosilane also includes a chlorosilane obtained in a hydrolysis condensation reaction between an organometallic compound having a protected hydroxyl group in the molecule and a dialkyl dichlorosilane compound.

In these protected hydroxyl groups, the group which protects the hydroxyl group includes, for instance, an alkyl group, a silyl group and an ester group which are usually applied as a group for protecting the hydroxyl group. Specifically, examples of the group can include a methoxymethyl group, a benzyl oxymethyl group, a t-butoxymethyl group, a 2-methoxyethoxymethyl group, a 2,2,2-trichloroethoxymethyl group, a 2-(trimethyl silyl)ethoxymethyl group, a tetrahydropyranyl group, a 3-bromotetrahydropyranyl group, a tetrahydrothiopyranyl group, a 4-methoxytetrahydropyranyl group, a tetrahydrofuranyl group, a 1-ethoxyethyl group, a 1-methyl-1-methoxyethyl group, a 1-(isopropoxy)ethyl group, a 2,2,2-trichloroethyl group, a 2-(phenyl selenyl)ethyl group, a t-butyl group, a benzyl group, a 3-methyl-2-picolyl-N-oxide group, a diphenyl methyl group, a 5-dibenzosuberyl group, a triphenyl methyl group, a 9-anthryl group, a trimethyl silyl group, a triethyl silyl group, an isopropyl dimethyl silyl group, a t-butyl dimethyl silyl group, a (triphenylmethyl)dimethyl silyl group, a t-butyl diphenyl silyl group, a methyl diisopropyl silyl group, a methyl-di-t-butyl silyl group, a tribenzyl silyl group, a triisopropyl silyl group, a triphenyl silyl group, a formyl group, an acetyl group, a 3-phenyl propionate group, a 3-benzoyl propionate group, an isobutyrate group, a 4-oxopentanoate group, a pivaloate group, an adamantate group, a benzoate group, a methoxycarbonyl group, an ethoxycarbonyl group, a 2,2,2-trichloroethoxycarbonyl group, an isobutyl oxycarbonyl group and a benzyl carbonate group.

The active hydrogen group contained in the polyorganosilsesquioxane resin obtained in the above described way is preferably a phenolic hydroxyl group and an alcoholic hydroxyl group, and more preferably is the phenolic hydroxyl group. The phenolic hydroxyl group represented by the following formula (1) is particularly preferable as a phenolic hydroxyl group. In addition, the reference characters in the formula (1) are all synonymous with those in the above description.

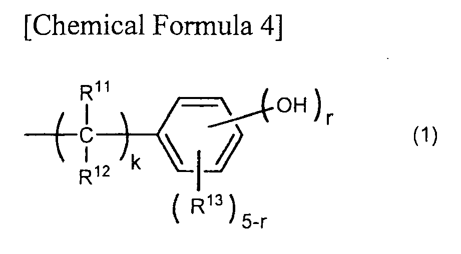

In the phenolic hydroxyl group represented by the above formula (1), the monovalent organic group which is represented by R¹¹ to R¹³ and has 1 to 20 carbon atoms may be any straight-chain, branched or cyclic group, and may be any one of a saturated group and an unsaturated group.

The monovalent organic group having 1 to 20 carbon atoms includes a straight-chain hydrocarbon group having 1 to 20 carbon atoms, a branched hydrocarbon group having 3 to 20 carbon atoms, a cyclic hydrocarbon group having 3 to 20 carbon atoms and an aromatic hydrocarbon group having 6 to 20 carbon atoms, for instance. The monovalent organic group is preferably any one of a straight-chain hydrocarbon group having 1 to 6 carbon atoms, a branched hydrocarbon group having 3 to 6 carbon atoms, a cyclic hydrocarbon group having 3 to 6 carbon atoms or an aromatic hydrocarbon group having 6 to 20 carbon atoms. In addition, these hydrocarbon groups may also have other groups with which some hydrogen atoms thereof are substituted. For instance, the cyclic hydrocarbon group may also be substituted with a fluorine atom, and the aromatic hydrocarbon group may also be substituted with an alkyl group and a halogen atom.

The monovalent organic groups having 1 to 20 carbon atoms include a methyl group, an ethyl group, a propyl group, a butyl group, a pentyl group, a hexyl group, an isopropyl group, an isobutyl group, a t-butyl group, a cyclopropyl group, a cyclobutyl group, a cyclopentyl group, a cyclohexyl group, a cyclopentynyl group, a cyclohexynyl group, a trifluoromethyl group, a trifluoroethyl group, a phenyl group, a naphthyl group, an anthryl group, a tolyl group, a xylyl group, a dimethyl phenyl group, a trimethyl phenyl group, an ethyl phenyl group, a diethyl phenyl group, a triethyl phenyl group, a propyl phenyl group, a butyl phenyl group, a methyl naphthyl group, a dimethyl naphthyl group, a trimethyl naphthyl group, a vinyl naphthyl group, an ethenyl naphthyl group, a methyl anthryl group, an ethyl anthryl group, a pentafluorophenyl group, a trifluoromethyl phenyl group, a chlorophenyl group and a bromophenyl group.

On the other hand, the alcoholic hydroxyl group preferably includes a group represented by the following formula (2). The reference characters in the formula are all synonymous with those in the above description, and examples of a monovalent organic group having 1 to 20 carbon atoms represented by R²¹ to R²⁶ can include the same group as in the above described formula (1).

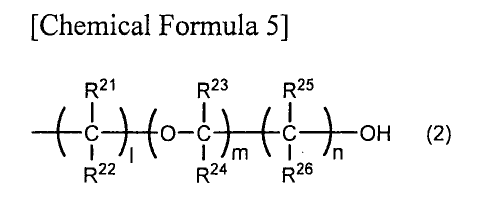

In addition, the first compound also includes another compound than the above described polyorganosilsesquioxane resin having two or more active hydrogen groups, which is obtained, for instance, by solely polymerizing a monomer compound (monomer) having the active hydrogen group and an unsaturated bond (double bond, for instance) in the molecule or copolymerizing the monomer compound with another copolymerizable compound (copolymerization polymer) than the monomer compound to form a polymer. The compound may also be a compound obtained by using a monomer having the protected active hydrogen group, polymerizing the monomer, and eliminating the protection for the monomer. A photopolymerization initiator or a thermal polymerization initiator can be used in these polymerization reactions.

The monomer having the active hydrogen group and the unsaturated double bond includes, for instance, aminostyrene, o-hydroxystyrene, m-hydroxystyrene, p-hydroxystyrene, vinyl benzyl alcohol, aminoethyl methacrylate, 2-hydroxyethyl (meth)acrylate, 2-hydroxypropyl (meth)acrylate, 3-hydroxypropyl (meth)acrylate, 2-hydroxybutyl (meth)acrylate, 2-hydroxyphenyl ethyl (meth)acrylate, ethylene glycol monovinyl ether and allyl alcohol. In the present specification, "(meth)acryl" is a collective term of acrylic and methacrylic, and means either or both of these substances.

In addition, the copolymerization monomer which is copolymerized with these monomers includes, for instance, a (meth)acrylic ester and a derivative thereof, styrene and a derivative thereof, vinyl acetate and a derivative thereof, (meth)acrylonitrile and a derivative thereof, a vinyl ester of an organic carboxylic acid and a derivative thereof, an allyl ester of an organic carboxylic acid and a derivative thereof, a dialkyl ester of fumaric acid and a derivative thereof, a dialkyl ester of maleic acid and a derivative thereof, a dialkyl ester of itaconic acid and a derivative thereof, an N-vinyl amide derivative of an organic carboxylic acid, maleimide and a derivative thereof, a terminal-unsaturated hydrocarbon and a derivative thereof, and an organic germanium derivative.

Among the copolymerization monomers, a monofunctional (meth)acrylate and a multifunctional (meth)acrylate can be applied to (meth)acrylic esters and a derivative thereof. The amount of the multifunctional (meth)acrylate to be used is occasionally restricted according to the properties of a target polymer.

The (meth)acrylic esters and derivatives thereof include, for instance, methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, hexyl (meth)acrylate, octyl (meth)acrylate, 2-ethylhexyl (meth)acrylate, decyl (meth)acrylate, isobornyl (meth)acrylate, cyclohexyl (meth)acrylate, phenyl (meth)acrylate, benzyl (meth)acrylate, 2-hydroxyethyl (meth)acrylate, 2-hydroxypropyl (meth)acrylate, 3-hydroxypropyl (meth)acrylate, 2-hydroxybutyl (meth)acrylate, 2-hydroxyphenyl ethyl (meth)acrylate, ethylene glycol di(meth)acrylate, propylene glycol di(meth)acrylate, 1,4-butanediol di(meth)acrylate, diethylene glycol di(meth)acrylate, triethylene glycol di(meth)acrylate, trimethylolpropane di(meth)acrylate, trimethylolpropane tri(meth)acrylate, pentaerythritol penta(meth)acrylate, N,N-dimethyl (meth)acrylamide, N,N-diethyl (meth)acrylamide and N-acryloyl morpholine.

In addition, the styrene and a derivative thereof include styrene, 2,4-dimethyl-α-methylstyrene, o-methylstyrene, m-methylstyrene, p-methylstyrene, 2,4-dimethylstyrene, 2,5-dimethylstyrene, 2,6-dimethylstyrene, 3,4-dimethylstyrene, 3,5-dimethylstyrene, 2,4,6-trimethylstyrene, 2,4,5-trimethylstyrene, pentamethyl styrene, o-ethylstyrene, m-ethylstyrene, p-ethylstyrene, o-chlorostyrene, m-chlorostyrene, p-chlorostyrene, o-bromostyrene, m-bromostyrene, p-bromostyrene, o-methoxystyrene, m-methoxystyrene, p-methoxystyrene, o-hydroxystyrene, m-hydroxystyrene, p-hydroxystyrene, 2-vinylbiphenyl, 3-vinylbiphenyl, 4-vinylbiphenyl, 1-vinylnaphthalene, 2-vinylnaphthalene, 4-vinyl-p-terphenyl, 1-vinylanthracene, α-methylstyrene, o-isopropenyl toluene, m-isopropenyl toluene, p-isopropenyl toluene, 2,4-dimethyl-α-methylstyrene, 2,3-dimethyl-α-methylstyrene, 3,5-dimethyl-α-methylstyrene, p-isopropyl-α-methylstyrene, α-ethylstyrene, α-chlorostyrene, divinylbenzene, divinyl biphenyl, diisopropylbenzene and 4-aminostyrene.

The (meth)acrylonitrile and a derivative thereof include acrylonitrile and methacrylonitrile. The vinyl ester of an organic carboxylic acid and a derivative thereof include vinyl acetate, vinyl propionate, vinyl butyrate, vinyl benzoate and divinyl adipate. The allyl ester of an organic carboxylic acid and a derivative thereof include allyl acetate, allyl benzoate, diaryl adipate, diaryl terephthalate, diallyl isophthalate and diallyl phthalate.

The dialkyl ester of fumaric acid and a derivative thereof include dimethyl fumarate, diethyl fumarate, diisopropyl fumarate, di-sec-butyl fumarate, diisobutyl fumarate, di-n-butyl fumarate, di-2-ethylhexyl fumarate and dibenzyl fumarate. The dialkyl ester of maleic acid and a derivative thereof include dimethyl maleate, diethyl maleate, diisopropyl maleate, di-sec-butyl maleate, diisobutyl maleate, di-n-butyl maleate, di-2-ethylhexyl maleate and dibenzyl maleate.

The dialkyl ester of itaconic acid and a derivative thereof include dimethyl itaconate, diethyl itaconate, diisopropyl itaconate, di-sec-butyl itaconate, di-isobutyl itaconate, di-n-butyl itaconate, di-2-ethylhexyl itaconate and dibenzyl itaconate. The N-vinyl amide derivative of an organic carboxylic acid includes N-methyl-N-vinyl acetamide. The maleimide and a derivative thereof include N-phenyl maleimide and N-cyclohexyl maleimide.

The terminal-unsaturated hydrocarbon and a derivative thereof include 1-butene, 1-pentene, 1-hexene, 1-octene, vinylcyclohexane, vinyl chloride and allyl alcohol. The organic germanium derivative includes allyl trimethyl germanium, allyl triethyl germanium, allyl tributyl germanium, trimethyl vinyl germanium and triethyl vinyl germanium.

Among these copolymerization monomers, an alkyl (meth)acrylate, styrene, (meth)acrylonitrile or allyl trimethyl germanium is preferable, and these compounds may be appropriately combined to be applied.

The photopolymerization initiator which is used for a polymerization reaction to form a polymer includes, for instance: a carbonyl compound such as acetophenone, 2,2-dimethoxy-2-phenylacetophenone, 2,2-diethoxyacetophenone, 4-isopropyl-2-hydroxy-2-methylpropiophenone, 2-hydroxy-2-methylpropiophenone, 4,4'-bis(diethyl amino)benzophenone, benzophenone, methyl(o-benzoyl)benzoate, 1-phenyl-1,2-propane dione-2-(o-ethoxycarbonyl)oxime, 1-phenyl-1,2-propane dione-2-(o-benzoyl)oxime, benzoin, benzoin methyl ether, benzoin ethyl ether, benzoin isopropyl ether, benzoin isobutyl ether, benzoin octyl ether, benzyl, benzyl dimethyl ketal, benzyl diethyl ketal and diacetyl; anthraquinone or a thioxanthone derivative such as methylanthraquinone, chloroanthraquinone, chlorothioxanthone, 2-methyl thioxanthone and 2-isopropyl thioxanthone; and a sulfur compound such as diphenyl disulfide and dithiocarbamate.

The thermal polymerization initiator can function as an initiator of a radical polymerization. The thermal polymerization initiator includes for instance: an azo-based compound such as 2,2'-azobisisobutyronitrile, 2,2'-azobisisovaleronitrile, 2,2'-azobis(2,4-dimethyl valeronitrile), 4,4'-azobis(4-cyanovaleric acid), 1,1'-azobis(cyclohexane carbonitrile), 2,2'-azobis(2-methylpropane) and 2,2'-azobis(2-methyl propionamidine)2hydrochloride; ketone peroxides such as methyl ethyl ketone peroxide, methyl isobutyl ketone peroxide, cyclohexanone peroxide and acetylacetone peroxide; diacyl peroxides such as isobutyl peroxide, benzoyl peroxide, 2,4-dichlorobenzoyl peroxide, o-methyl benzoyl peroxide, lauroyl peroxide and p-chlorobenzoyl peroxide; hydroperoxides such as 2,4,4-trimethyl pentyl-2-hydroperoxide, diisopropyl benzene peroxide, cumene hydroperoxide and t-butyl peroxide; dialkyl peroxides such as dicumyl peroxide, t-butyl cumyl peroxide, di-t-butyl peroxide and tris(t-butyl peroxy)triazine; peroxyketals such as 1,1-di-t-butyl peroxycyclohexane and 2,2-di(t-butyl peroxy)butane; alkyl peresters such as t-butyl peroxypivalate, t-butyl peroxy-2-ethyl hexanoate, t-butyl peroxyisobutyrate, di-t-butyl peroxyhexahydroterephthalate, di-t-butyl peroxyazelate, t-butyl peroxy-3,5,5-trimethyl hexanoate, t-butyl peroxyacetate, t-butyl peroxybenzoate and di-t-butyl peroxytrimethyl adipate; and percarbonates such as diisopropyl peroxydicarbonate, di-sec-butyl peroxydicarbonate and t-butyl peroxyisopropyl carbonate.

The above described first compound preferably has the weight average molecular weight of 3,000 to 1,000,000 and more preferably of 5,000 to 500,000 in terms of polystyrene. By having such a weight average molecular weight, the first compound shows an advantage of giving adequate flatness and uniformity to the obtained film.

(Second compound) Next, a second compound will be described below.

The second compound is a low-molecular compound having two or more dissociable groups in the molecule, and specifically includes a compound having a structure in which two or more dissociable groups are bonded to a low-molecular (monomer) structure. A form of this low-molecular structure is preferably, for instance, an alkyl structure or a benzene ring which may have a substituent.

In the second compound, a dissociable group includes a blocked isocyanato group (hereinafter referred to as "block isocyanato group") and a blocked isothiocyanato group (hereinafter referred to as "block isothiocyanato group").

The dissociable group is preferably a block isocyanato group or a block isothiocyanato group. The block isocyanato group or the block isothiocyanato group produces an isocyanato group or isothiocyanato group which is a functional group that becomes reactive by heat, respectively.

The block isocyanato group or the block isothiocyanato group is an isocyanato group or an isothiocyanato group which is blocked by a blocking agent, respectively. This blocking agent is a compound which reacts with the isocyanato group or the isothiocyanato group and consequently can form a group which protects these groups, and includes, for instance, a compound having one active hydrogen group which can react with the isocyanato group or the isothiocyanato group. The blocking agent is preferably an agent which dissociates by being heated to a temperature of 170°C or lower after having been blocked, and produces the isocyanato group or the isothiocyanato group again, in particular.

Such blocking agents include compounds such as an alcohol-based compound, a phenol-based compound, an active-methylene-based compound, a mercaptan-based compound, an acid-amide-based compound, an acid-imide-based compound, an imidazole-based compound, a urea-based compound, an oxime-based compound, an amine-based compound, an imide-based compound, a pyridine-based compound, and a pyrazole-based compound, for instance. The blocking agents can be used singly or in combination of two or more thereof. Among them, the oxime-based compound or the pyrazole-based compound is preferable.

More specifically, in the blocking agents, the alcohol-based compound includes methanol, ethanol, propanol, butanol, 2-ethylhexanol, methyl cellosolve, butyl cellosolve, methyl carbitol, benzyl alcohol and cyclohexanol, and the phenol-based compound includes phenol, cresol, ethylphenol, butylphenol, nonylphenol, dinonylphenol, styrenated phenol and a hydroxybenzoate. The active-methylene-based compound includes dimethyl malonate, diethyl malonate, methyl acetoacetate, ethyl acetoacetate and acetylacetone, and the mercaptan-based compound includes butyl mercaptan and dodecyl mercaptan.

The acid-amide-based compound which is the blocking agent includes acetanilide, acetic acid amide, ε-caprolactam, δ-valerolactam and γ-butyrolactam, and the acid-imide-based compound includes succinic acid imide and maleic acid imide. The imidazole-based compound includes imidazole and 2-methylimidazole, and the urea-based compound includes urea, thiourea and ethylene urea. The amine-based compound includes diphenyl amine, aniline and carbazole, and the imine-based compound includes ethyleneimine and polyethyleneimine. A bisulfite includes sodium bisulfite, and the pyridine-based compound includes 2-hydroxypyridine and 2-hydroxyquinoline. Furthermore, the oxime-based compound includes formaldoxime, acetaldoxime, acetoxime, methyl ethyl ketoxime and cyclohexanone oxime, and the pyrazole-based compound includes 3,5-dimethylpyrazole and 3,5-diethylpyrazole.

The above described block isocyanato group or block isothiocyanato group preferably includes a group represented by the following formula (3 a) or a group represented by the following formula (3b). The reference characters in these formulae are all synonymous with those in the above description. When a group represented by R³¹ to R³⁵ in the formulae is a monovalent organic group having 1 to 20 carbon atoms, specific examples of the group preferably include a group similar to the monovalent organic group having 1 to 20 carbon atoms in the above described formula (1).

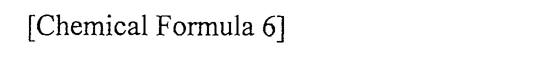

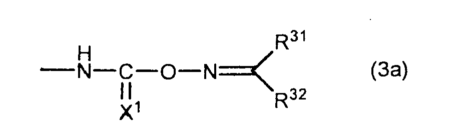

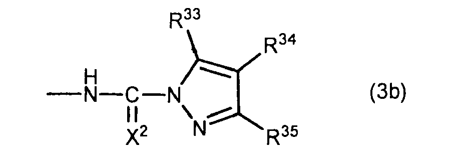

The above-described block isocyanato group includes O-(methylidene amino)carboxyamino group, O-(1-ethylidene amino)carboxyamino group, O-(1-methyl ethylidene amino)carboxyamino group, O-[1-methyl propylidene amino]carboxyamino group, 1-(3,5-dimethyl pyrazolyl)carbonyl amino group, 1-(3-ethyl-5-methyl pyrazolyl)carbonyl amino group, 1-(3,5-diethyl pyrazolyl)carbonyl amino group, 1-(3-propyl-5-methyl pyrazolyl)carbonyl amino group and 1-(3-ethyl-5-propyl pyrazolyl)carbonyl amino group.

The block isothiocyanato group includes O-(methylidene amino)thiocarboxyamino group, O-(1-ethylidene amino)thiocarboxyamino group, O-(1-methyl ethylidene amino)thiocarboxyamino group, O-[1-methyl propylidene amino]thiocarboxyamino group, 1-(3,5-dimethyl pyrazolyl)thiocarbonyl amino group, 1-(3-ethyl-5-methyl pyrazolyl)thiocarbonyl amino group, 1-(3,5-diethyl pyrazolyl)thiocarbonyl amino group, 1-(3-propyl-5-methyl pyrazolyl)thiocarbonyl amino group and 1-(3-ethyl-5-propyl pyrazolyl)thiocarbonyl amino group.

More specifically, the second compound having these block isocyanato group or block isothiocyanato group as the dissociable group preferably includes a compound represented by the following formula (4a) or a compound represented by the following formula (4b):

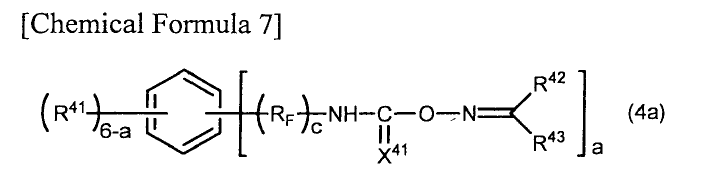

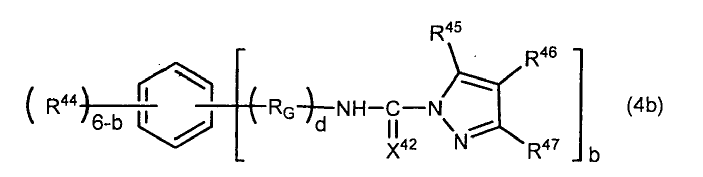

The reference characters in the above described formulae (4a) and (4b) are defined as above. When the group represented by R⁴¹ to R⁴⁷ in the formulae is a monovalent organic group having 1 to 20 carbon atoms, specific examples of the group preferably include a group similar to the monovalent organic group having 1 to 20 carbon atoms in the above described formula (1). The divalent organic groups having 1 to 20 carbon atoms represented by R_{F} and R_{G} include divalent groups in which one hydrogen atom out of hydrogen atoms contained in the above described monovalent organic groups becomes a coupling site with another structure.

The divalent aliphatic hydrocarbon group includes, for instance, a methylene group, an ethylene group, a propylene group, a butylene group, a pentylene group, a hexylene group, an isopropylene group, an isobutylene group, a dimethyl propylene group, a cyclopropylene group, a cyclobutylene group, a cyclopentylene group and a cyclohexylene group. Specific examples of the divalent aromatic hydrocarbon group include a phenylene group, a naphthylene group, an anthrylene group, a dimethyl phenylene group, a trimethyl phenylene group, an ethylene phenylene group, a diethylene phenylene group, a triethylene phenylene group, a propylene phenylene group, a butylene phenylene group, a methyl naphthylene group, a dimethyl naphthylene group, a trimethyl naphthylene group, a vinyl naphthylene group, an ethenyl naphthylene group, a methyl anthrylene group and an ethyl anthrylene group.

Such a second compound can be obtained by making the above-described blocking agent react with a low-molecular compound having two or more isocyanato groups or isothiocyanato groups to convert the isocyanato group or the isothiocyanato group which is a reactive functional group, into the block isocyanato group or the block isothiocyanato group of the dissociable group, for instance. In this reaction, an organic solvent, a catalyst and the like may be appropriately added.

The low-molecular compounds having two or more isocyanato groups or isothiocyanato groups include, for instance, ortho-phenylene diisocyanate, meta-phenylene diisocyanate, para-phenylene diisocyanate, tolylene diisocyanate, tetramethylene diisocyanate and hexamethylene diisocyanate.

Examples of the low-molecular compound having two or more block isocyanato groups or block isothiocyanato groups which can be obtained by the above-described reaction can include the following compounds.

Specifically, the low-molecular compound includes 1,2-di[O-(methylidene amino)carboxyamino]benzene, 1,3-di[O-(inethylidene amino)carboxyamino]benzene, 1,4-di[O-(methylidene amino)carboxyamino]benzene, 1,2-di[O-(1'-ethylidene amino)carboxyamino]benzene, 1,3-did[O-(1'-ethylidene amino)carboxyamino]benzene, 1,4-di[O-(1'-ethylidene amino)carboxyamino]benzene, 1,2-di[O-(1'-methyl ethylidene amino)carboxyamino]benzene, 1,3-di[O-(1'-methyl ethylidene amino)carboxyamino]benzene, 1,4-di[O-(1'-methyl ethylidene amino)carboxyamino]benzene, 1,2-di[O-[1'-methyl propylideneamino] carboxyamino]benzene, 1,3-di[O-[1'-methyl propylidene amino]carboxyamino]benzene, 1,4-di[O-[1'-methyl propylidene amino]carboxyamino]benzene, 1,2-di[1'-(3',5'-dimethyl pyrazolyl)carbonyl amino]benzene, 1,3-di[1'(3',5'-dimethyl pyrazolyl)carbonyl amino]benzene, 1,4-di[1'-(3',5'-dimethyl pyrazolyl)carbonyl amino]benzene, 1,2-di[1'-(3'-ethyl-5'-methyl pyrazolyl)carbonyl amino]benzene, 1,3-di[1-(3'-ethyl-5'-methyl pyrazolyl)carbonyl amino]benzene, 1,4-di[1'-(3'-ethyl-5'-methyl pyrazolyl)carbonyl amino]benzene, 1,2-di[1'-(3',5'-diethyl pyrazolyl)carbonyl amino]benzene, 1,3-di[1'-(3',5'-diethyl pyrazolyl)carbonyl amino]benzene, 1,4-di[1'-(3',5'-diethyl pyrazolyl)carbonyl amino]benzene, 1,2-di[1'-(3'-propyl-5'-methyl pyrazolyl)carbonyl amino]benzene, 1,3-di[1'-(3'-propyl-5'-methyl pyrazolyl)carbonyl amino]benzene, 1,4-di[1'-(3'-propyl-5'-methyl pyrazolyl)carbonyl amino]benzene, 1,2-di[1'-(3'-ethyl-5'-propyl pyrazolyl)carbonyl amino]benzene, 1,3-di[1'-(3'-ethyl-5'-propyl pyrazolyl)carbonyl amino]benzene, 1,4-di[1'-(3'-ethyl-5'-propyl pyrazolyl)carbonyl amino]benzene, 1,4-di[O-(methylidene amino)carboxyamino]butane, 1,4-di[O-(1'-methyl ethylidene amino)carboxyamino]butane, 1,6-di[O-(methylidene amino)carboxyamino]hexane, 1,6-di[O-(1'-methyl ethylidene amino)carboxyamino]hexane, 1,2-di[O-(methylidene amino)thiocarboxyamino]benzene, 1,3-di[O-(methylidene amino)thiocarboxyamino]benzene, 1,4-di[O-(methylidene amino)thiocarboxyamino]benzene, 1,2-di[O-(1'-ethylidene amino)thiocarboxyamino]benzene, 1,3-di[O-(1'-ethylidene amino)thiocarboxyamino]benzene, 1,4-di[O-(1'-ethylidene amino)thiocarboxyamino] benzene, 1,2-di[O-(1'-methyl ethylidene amino)thiocarboxyamino]benzene, 1,3-di[O-(1'-methyl ethylidene amino)thiocarboxyamino]benzene, 1,4-di[O-(1'-methyl ethylidene amino)thiocarboxyamino]benzene, 1,2-di[O-[1'-methyl propylidene amino]thiocarboxyamino]benzene, 1,3-di[O-[1'-methyl propylidene amino]thiocarboxyamino]benzene, 1,4-di[O-[1'-methyl propylidene amino]thiocarboxyamino]benzene, 1,2-di[1'-(3',5'-dimethyl pyrazolyl)thiocarbonyl amino]benzene, 1,3-di[1'-(3',5'-dimethyl pyrazolyl)thiocarbonyl amino]benzene, 1,4-di[1'-(3',5'-dimethyl pyrazolyl)thiocarbonyl amino]benzene, 1,2-di[1'-(3'-ethyl-5'-methyl pyrazolyl)thiocarbonyl amino]benzene, 1,3-di[1'-(3'-ethyl-5'-methyl pyrazolyl)thiocarbonyl amino]benzene, 1,4-di[1'(3'-ethyl-5'-methyl pyrazolyl)thiocarbonyl amino]benzene, 1,2-di[1'-(3',5'-diethyl pyrazolyl)thiocarbonyl amino]benzene, 1,3-di[1'-(3',5'-diethyl pyrazolyl)thiocarbonyl amino]benzene, 1,4-di[1'-(3',5'-diethyl pyrazolyl)thiocarbonyl amino]benzene, 1,2-di[1'-(3'-propyl-5'-methyl pyrazolyl)thiocarbonyl amino]benzene, 1,3-di[1'-(3'-propyl-5'-methyl pyrazolyl)thiocarbonyl amino]benzene, 1,4-di[1'-(3'-propyl-5'-methyl pyrazolyl)thiocarbonyl amino]benzene, 1,2-di[1'-(3'-ethyl-5'-propyl pyrazolyl)thiocarbonyl amino]benzene, 1,3-di[1'-(3'-ethyl-5'-propyl pyrazolyl)thiocarbonyl amino]benzene, 1,4-di[1'-(3'-ethyl-5'-propyl pyrazolyl)thiocarbonyl amino]benzene, 1,4-di[O-(methylidene amino)thiocarboxyamino]butane, 1,4-di[O-(1'-methyl ethylidene amino)thiocarboxyamino]butane, 1,6-di[O-(methylidene amino)thiocarboxyamino]hexane and 1,6-di[O-(1'-methyl ethylidene amino)thiocarboxyamino]hexane.

(Content ratio in composition for insulating layer) The composition for an insulating layer according to the present embodiment contains the above described first and second compounds, and the composition preferably contains 20 to 90 mass% of the first compound, and more preferably 40 to 80 mass%, in the total of the first and second compounds. When the composition satisfies such a content ratio, the insulating properties and the withstand voltage of the insulating layer obtained from the composition for an insulating layer tend to be particularly adequately obtained.

(Other components) The composition for an insulating layer according to the present embodiment may contain a curing catalyst, a crosslinking agent, a surface active agent, a leveling agent, a thickener and the like other than the first and second compounds according to desired characteristics, in a range that does not impair the effect of the present invention.

[Organic thin film transistor] Next, preferred embodiments of an organic thin film transistor (hereinafter, abbreviated simply as "transistor") including an insulating layer formed from the above described composition for an insulating layer will be described below.

The transistor according to the preferred embodiments includes a transistor including a source electrode, a drain electrode, an organic semiconductor layer which becomes a current path between the source electrode and the drain electrode, a gate electrode which controls an electric current passing through the current path, and an insulating layer which insulates the organic semiconductor layer from the gate electrode, wherein the insulating layer is formed of a cured substance of the composition for an insulating layer in the above described embodiment.

The transistor also include a transistor including a source electrode, a drain electrode, an organic semiconductor layer which becomes a current path between the source electrode and the drain electrode, a gate electrode which controls an electric current passing through the current path, an insulating layer which insulates the organic semiconductor layer from the gate electrode, and a protective layer provided so as to cover these structures, wherein the protective layer is formed of the cured substance of the composition for an insulating layer according to the above described embodiment. Examples of these transistors will be more specifically described below.

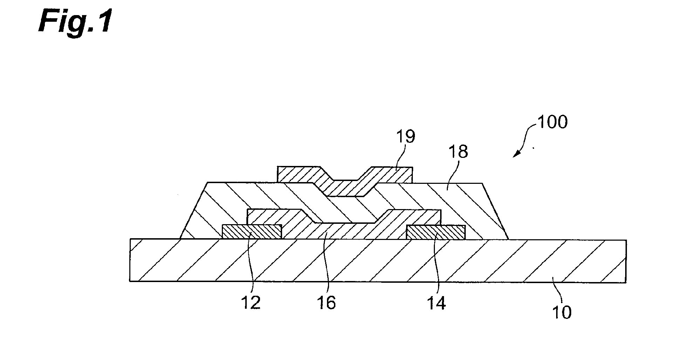

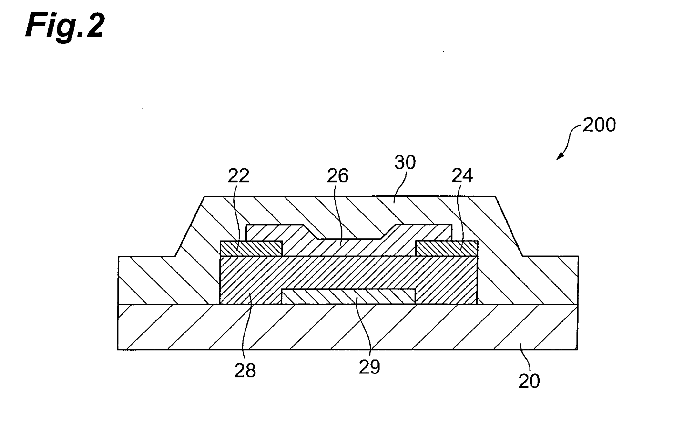

Figure 1 is a view schematically illustrating a sectional structure of a transistor according to a first embodiment, and Figure 2 is a view schematically illustrating a sectional structure of a transistor according to a second embodiment. The transistor of the first embodiment illustrated in Figure 1 is a so-called top gate type transistor, and the transistor of the second embodiment illustrated in Figure 2 is a so-called bottom gate type transistor, but the transistor of the present invention is not necessarily limited to these forms.

As is illustrated in Figure 1, a transistor 100 of the first embodiment has a source electrode 12, a drain electrode 14, an organic semiconductor layer 16, a gate insulating layer (insulating layer) 18 and a gate electrode 19 provided on a substrate 10 in this order.

In this transistor 100, the source electrode 12 and the drain electrode 14 are provided on the substrate 10 so as to be separated from each other by a predetermined space. The organic semiconductor layer 16 is formed on the substrate 10 so as to cover at least one part of each of the source electrode 12 and the drain electrode 14. The organic semiconductor layer 16 is brought in contact with both the source electrode 12 and the drain electrode 14, and thereby becomes a current path between these electrodes.

In addition, the gate insulating layer 18 is provided so as to cover all of the source electrode 12, the drain electrode 14 and the organic semiconductor layer 16 which have been formed in the lower part. The gate electrode 19 is further provided on this gate insulating layer 18. Thus, the gate insulating layer 18 is formed between the organic semiconductor layer 16 and the gate electrode 19, and thereby insulates the organic semiconductor layer 16 from the gate electrode 19.

On the other hand, as is illustrated in Figure 2, a transistor 200 of the second embodiment has a gate electrode 29, a gate insulating layer 28, a source electrode 22 and a drain electrode 24, an organic semiconductor layer 26 and a topcoat 30 provided on a substrate 20 in this order.

In this transistor 200, the gate electrode 29 is directly provided on the substrate 20, and the gate insulating layer 28 is formed so as to cover this gate electrode 29. The source electrode 22 and the drain electrode 24 are provided on the gate insulating layer 28 so as to be separated from each other by a predetermined space. The organic semiconductor layer 26 is provided on the gate insulating layer 28 so as to cover at least one part of each of the source electrode 22 and the drain electrode 24.

The organic semiconductor layer 26 is brought in contact with both the source electrode 22 and the drain electrode 24, and thereby becomes a current path between these electrodes. In addition, because the gate insulating layer 28 is formed between the organic semiconductor layer 26 and the gate electrode 29, the organic semiconductor layer 26 and the gate electrode 29 are insulated from each other.

In the transistor 200, the topcoat 30 is provided on the substrate 20 so as to cover all of the above described element structure. This topcoat 30 functions as a protective layer, and can protect the organic semiconductor layer 26 which easily deteriorates by being brought in contact with the element structure, particularly, the outer part.

In the above described transistors 100 and 200, firstly, the substrates 10 and 20 are formed of a glass substrate, a plastic substrate and the like. However, because the transistor of the present invention can be formed at a low temperature as will be described later, a plastic substrate which ordinarily easily causes expansion, contraction and the like by heat can be adequately applied to the substrates 10 and 20. By applying the plastic substrate to the substrate, the weight of the transistors 100 and 200 can be easily reduced and the transistors can become flexible.

The gate electrodes 19 and 29 are formed from an electroconductive material. Examples of the electroconductive material can include: a metal such as aluminum, gold, platinum, silver, copper, chromium, nickel and titanium; an electroconductive oxide such as ITO; and an electroconductive polymer such as a mixed polymer of poly(3,4-ethylene dioxythiophene) and polystyrene sulfonate. In addition, an electroconductive material in which fine particles of metal, carbon black or fine powders of graphite are dispersed in a binder also can be applied to the electroconductive material. Furthermore, an electrode formed from the same electroconductive material as that of the gate electrodes 19 and 29 can be applied to the source electrodes 12 and 22 and the drain electrodes 14 and 24 as well.

A substance formed of a low-molecular organic semiconductor material and a polymer organic semiconductor material can be applied to the organic semiconductor layers 16 and 26. The low-molecular organic semiconductor material includes pentacene, for instance. In addition, the polymer organic semiconductor material includes poly-3-hexylthiophene (P3HT) and fluorene dithiophene (F8T2), for instance. The organic semiconductor layers 16 and 26 are formed from an organic material which can function as a semiconductor.

The gate insulating layers (insulating layers) 18 and 28 in the transistors 100 and 200 are formed of a cured substance of the composition for an insulating layer according to the above described preferred embodiments. In addition, the topcoat 30 in the transistor 200 is also formed of the cured substance of the composition for an insulating layer.

Here, the cured substance of the composition for an insulating layer is in a state of having a structure formed therein in which the first compound and the second compound are repeatedly bonded to each other, by a reaction caused between the first compound and the second compound. Such a reaction of the first compound and the second compound is caused by such a mechanism that a reactive functional group is firstly formed from a dissociable group in the second compound by the application of the electromagnetic radiations or heat, and the reactive functional group formed in the second compound subsequently reacts with the active hydrogen group in the first compound. Thus, a composition for an insulating layer can be cured by the application of the electromagnetic radiations or heat. The electromagnetic radiations is an electromagnetic wave having a predetermined wavelength, and for instance, X-rays, ultraviolet rays and the like correspond to the electromagnetic wave.

[Method for manufacturing organic thin film transistor] Next, preferred embodiments of a method for manufacturing an organic thin film transistor (transistor) having the above-described structure will be described below.

The method for manufacturing the transistor of the preferred embodiment is a method for manufacturing the organic thin film transistor including a source electrode, a drain electrode, an organic semiconductor layer which becomes a current path between the source electrode and the drain electrode, a gate electrode which controls an electric current passing through the current path, and an insulating layer which insulates the organic semiconductor layer from the gate electrode, wherein the insulating layer is formed on a face to have an insulating layer formed thereon, by applying and curing the above described composition for insulating layer.

Firstly, in the manufacture of a transistor 100 in a first embodiment, a substrate 10 is prepared, and a source electrode 12 and a drain electrode 14 are formed by depositing the above-described electroconductive material on this substrate 10 with a well-known method such as a vacuum vapor-deposition method, a sputtering method, a printing method and an ink jet method.

Subsequently, an organic semiconductor layer 16 is formed on the substrate 10 already having the source electrode 12 and the drain electrode 14 formed thereon so as to cover one part of each of these electrodes. The organic semiconductor layer 16 is preferably formed, for instance, by dissolving the above-described low-molecular or polymer organic semiconductor material into a dissolvable solvent, applying the solution onto the substrate and drying the solution.

As the solvent to be used here, any solvent is usable as long as the solvent can dissolve the organic semiconductor material, and preferably has a boiling point of 50°C to 200°C at normal pressure from the viewpoint of being removed by drying at as low a temperature as possible. The solvent includes an organic solvent such as chloroform, toluene, anisole, 2-heptanone and propylene glycol monomethyl ether acetate. The solution of the organic semiconductor material can be applied, for instance, with a spin coat method, a die coater method, a screen printing method, an ink jet method and the like.

Subsequently, an insulating layer 18 is formed on the substrate 10 already having the source electrode 12, the drain electrode 14 and the organic semiconductor layer 16 formed thereon so as to cover the electrodes and the layer. The insulating layer 18 can be formed by applying the above-described composition for an insulating layer, and curing the insulating composition. In the case of the transistor 100 to be manufactured in this first embodiment, the upper surface of the stacked structure in which the source electrode 12, the drain electrode 14 and the organic semiconductor layer 16 are formed on the substrate 10 corresponds to "face to have an insulating layer formed thereon". The detailed method for forming the insulating layer 18 will be described later.

After that, a gate electrode 19 is formed on the insulating layer 18 with the same method as that for the source electrode 12 and the drain electrode 14. Thereby, the transistor 100 of the first embodiment illustrated in Figure 1 is obtained.

On the other hand, as for a transistor 200 of a second embodiment, firstly, a gate electrode 29 is formed on a substrate 20 in a similar way to that in the first embodiment. Subsequently, a gate insulating layer 28 is formed on the substrate 20 so as to cover this gate electrode 29. The method for forming the gate insulating layer 28 will be described later, but in the second embodiment, the upper surface of the stacked structure in which the gate electrode 29 is formed on the substrate 20 corresponds to "face to have an insulating layer formed thereon".

Then, a source electrode 22 and a drain electrode 24 are formed on the gate insulating layer 28, and an organic semiconductor layer 26 is formed thereon so as to cover one part of each of these electrodes. These operations can be conducted in a similar way to that in the first embodiment. The transistor 200 of the second embodiment illustrated in Figure 2 is obtained by forming a topcoat 30 so as to cover the gate electrode 29, the gate insulating layer 28, the source electrode 22, the drain electrode 24 and the organic semiconductor layer 26 which have been formed on the substrate 20.

The method for forming the gate insulating layers 18 and 28 in these transistors 100 and 200 will be specifically described below.

In the formation of the gate insulating layers 18 and 28, firstly, the above-described composition for an insulating layer is applied onto the face on which these gate insulating layers are to be formed. The composition for an insulating layer can be applied, for instance, in a state of a solution in which the composition for an insulating layer is dissolved in an organic solvent. The organic solvent to be used for this solution needs to be capable of dissolving components in the composition for an insulating layer therein, and is preferably, for instance, an organic solvent which has a boiling point of 100°C to 200°C at normal pressure because of being easily removed by drying. Such an organic solvent includes 2-heptanone, propylene glycol monomethyl ether acetate, and 1-butanol.

The solution containing the composition for an insulating layer can be applied with a spin coating method, a die coater method, a screen printing method, an ink jet method and the like. In addition, a leveling agent, a surface active agent, a curing catalyst and the like may be added to the solution of the composition for an insulating layer, as needed.

Next, the solution of the composition for an insulating layer applied in such a way as was described above is dried to remove the organic solvent, and thereby a layer formed of the composition for an insulating layer is formed. The drying can be performed by heating to a level of a temperature at which the organic solvent volatilizes. At this time, from the viewpoint of forming the transistor at a low temperature, it is preferable not to heat the solution up to an excessively high temperature.

Then, the gate insulating layers 18 and 28 can be formed by curing the layer formed of the composition for an insulating layer. The layers can be cured by irradiation with the electromagnetic radiations or by heating as was described above. For instance, when the second compound in the composition for an insulating layer has a block isocyanato group or a block isothiocyanato group as a dissociable group, the layer can be cured by heating.

In this case, the heating temperature is preferably 60 to 250°C, and more preferably is 80 to 200°C. If the heating temperature exceeds 250°C, when a plastic substrate is used, for instance, the expansion and contraction may not be sufficiently suppressed. On the other hand, if the heating temperature is lower than 60°C, the composition for an insulating layer is not sufficiently cured, and effects of reducing a leakage current, enhancing the withstand voltage and stabilizing hysteresis may not be sufficiently obtained.

In addition, the topcoat 30 in the transistor 200 also can be formed by forming the element structure of a transistor and then applying the composition for an insulating layer so as to cover the element structure and curing the applied composition in a similar way to that for the above described gate insulating layers 18 and 28.

In addition, in the method for manufacturing such transistors 100 and 200, a self-organization monomolecular film layer may be formed on the gate insulating layers 18 and 28 (not shown). By forming such a self-organization monomolecular film layer, effects such as enhancement of the withstand voltage and improvement in transistor characteristics can be obtained.

The self-organization monomolecular film layer can be formed, for instance, by treating the gate insulating layers 18 and 28 with an alkyl chlorosilane compound or an alkyl alkoxysilane compound. It is considered that thus formed self-organization monomolecular film layer has a structure in which the alkyl chlorosilane compound or the alkyl alkoxysilane compound causes hydrolysis/condensation and the like, and has a form of interacting with the surfaces of the gate insulating layers 18 and 28 through an ion bond, a hydrogen bond and the like.

The film layer formed by the treatment of the alkyl chlorosilane compound or the alkyl alkoxysilane compound can be formed, for instance, by applying a solution in which these compounds are dissolved into the organic solvent so as to become 1 to 10 wt%, onto the gate insulating layers 18 and 28, and drying the solution.

The alkyl chlorosilane compound includes, for instance, methyl trichlorosilane, ethyl trichlorosilane, butyl trichlorosilane, decyl trichlorosilane and octadecyl trichlorosilane. The alkyl alkoxysilane compound includes methyl trimethoxysilane, ethyl trimethoxysilane, butyl trimethoxysilane, decyl trimethoxysilane and octadecyl trimethoxysilane.

[Display member and display] Next, a display member and a display using the transistor according to the above described embodiment will be described below. In the following description, a structure in which an organic EL device is used as a display is taken as an example, but the display which can be applied to the present invention is not limited to this display.

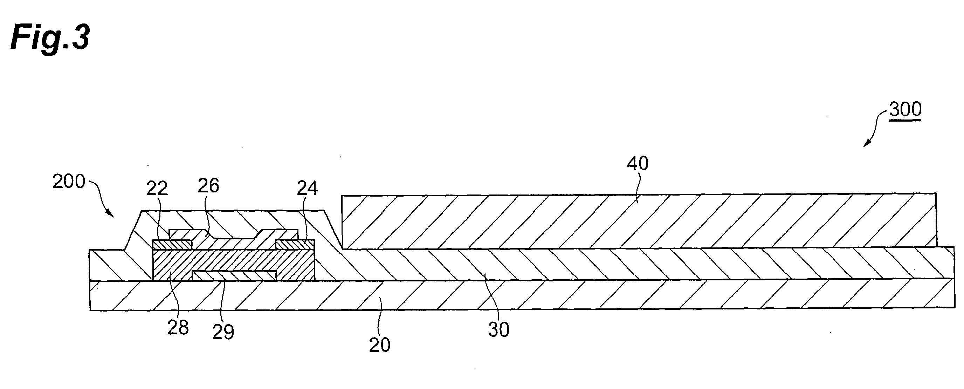

Figure 3 is a view schematically illustrating a sectional structure of a display according to a preferred embodiment. As is illustrated in Figure 3, the display 300 of the present embodiment has a structure having a transistor 200 and an organic EL device 40 provided therein. This display 300 constitutes one pixel in the display, and the transistor 200 is connected to the organic EL device 40 to control the light emission of this organic EL device 40. An actual display has a large number of such displays 300 provided therein and thereby can display an image.

In the display 300, the transistor 200 has the same structure as the above-described transistor 200 in the second embodiment. The substrate 20 in this transistor 200 extends to its plane direction, and serves as a substrate for mounting the organic EL device 40 thereon as well. In addition, a topcoat 30 in the transistor 200 is arranged between the substrate 20 and the organic EL device 40. An organic EL device having a well-known structure can be applied to the organic EL device 40.

Like such a display 300, the transistor 200 of one embodiment of the transistor according to the present invention can be preferably used as a display member to be used for a display. Such a transistor 200 can sufficiently suppress expansion and contraction of the substrate 20 even when a plastic plate is used as the substrate, for instance, because a gate insulating layer 28 and a topcoat 30 which need to be conventionally formed at a high temperature can be formed at a low temperature as was described above. When a device that may be shown in the display 300 is downsized so as to provide more pixels in the actual display, the deformation of the substrate tends to exert a large influence on display characteristics, but in the present embodiment, such a deformation of the substrate can be suppressed because the transistor 200 which can be formed at a low temperature is used as a display member, and the display 300 can be easily narrowed.

### Examples

The present invention will be described further in detail below with reference to examples, but the present invention is not limited to these examples.

### [Synthesis of first and second compounds]

### (Synthesis Example 1)

A tetrahydrofuran solution of 1,3-phenylene diisocyanate was obtained by replacing the inner part of a three necked flask with the capacity of 500 ml with nitrogen, to which a balanced dropping funnel with the capacity of 50 ml, a three necked cock and a mechanical stirrer are attached, then charging 25.0 g of 1,3-phenylene diisocyanate (product made by Wako Pure Chemical Industries, Ltd.) and 250 ml of dehydrated tetrahydrofuran into the three necked flask, and stirring the mixture to dissolve the 1,3-phenylene diisocyanate. Then, the reaction flask was placed in an ice bath, and butanone ketoxime (product made by Wako Pure Chemical Industries, Ltd.) was slowly added dropwise into the tetrahydrofuran solution of the 1,3-phenylene diisocyanate while the mixture liquid was stirred at 200 rpm. After the addition was finished, the resultant mixture was reacted while being continuously stirred in the ice bath for 1 hour and then further being stirred at room temperature overnight, and a transparent and light yellow reaction mixture was obtained.

The obtained reaction mixture was added dropwise into 1,000 ml of ion-exchanged water while the resultant mixture was stirred, the supernatant was then removed, and a viscous solid was obtained. The obtained solid was redissolved into 200 ml of ethanol, an insoluble matter was filtered with a filter paper, the ethanol was distilled off under a reduced pressure. Thereby, 1,3-di[O-(1'-methyl ethylidene amino)carboxyamino]benzene of the second compound was obtained in a viscous solid state (The amount of the obtained viscous solid was 45 g.).

(Synthesis Example 2) A 2-(4'-hydroxyphenyl)ethyl-dimethyl silyl-polysilsesquioxane resin was obtained by charging 60 g of a 42.4 wt% 2-heptanone solution of a 2-(4'-hydroxyphenyl) ethyl-dimethylsilyl-polysilsesquioxane resin (BOPH resin; made by Toagosei Co., Ltd., weight average molecular weight = 10,000 in terms of polystyrene) into an eggplant-type flask with a capacity of 300 ml, and distilling off 2-heptanone with the use of a rotary evaporator under a reduced pressure.

Into the obtained resin, 30 g of 1-butanol was added to redissolve the obtained resin and the solvent was distilled off again with the use of a rotary evaporator. This operation of redissolution and solvent distillation was repeated 3 times, and a 1-butanol solution containing 30 wt% of the 2-(4'-hydroxyphenyl)ethyl-dimethyl silyl-polysilsesquioxane resin which was the first compound was prepared finally by adjusting the amount of 1-butanol to be added.

### [Example 1]

### (Preparation of solution of composition for insulating layer)

A homogeneous application solution (solution of composition for insulating layer) was prepared by charging 3.00 g of a 1-butanol solution containing 30 wt% of a 2-(4'-hydroxyphenyl)ethyl-dimethyl silyl-polysilsesquioxane resin obtained in Synthesis Example 2, 0.27 g of 1,3-di[O-(1'-methyl ethylidene amino)carboxyamino]benzene obtained in Synthesis Example 1 and 5.70 g of 1-butanol into a sample bottle with a capacity of 10 ml, and dissolving the compound while stirring the mixture.

(Formation of insulating layer) Then, an insulating layer was obtained by filtering the obtained application solution with the use of a membrane filter with pores of 0.2 µm, spin-coating the filtrate onto a silicon wafer, and heating the wet film on a hot plate at 150°C for 90 minutes.

(Evaluation for solvent resistance of insulating layer) As a result of having added toluene or chloroform dropwise onto the obtained insulating layer, the insulating layer did not dissolve in the solvent.

(Evaluation for withstand voltage of insulating layer) As a result of having peeled off one part of the insulating layer and having measured its film thickness with a profilometer (made by KLM-Tencor Japan Ltd.), the film thickness was 185 nm.

As a result of having vapor-deposited an aluminum electrode on this insulating layer, and measured its dielectric breakdown voltage with the use of a vacuum prober (BCT22MDC-5-HT-SCU made by Nagase Electronic Equipments Service Co. LTD.), the insulating layer did not cause the dielectric breakdown even when 100 V was applied to the insulating layer. In addition, the leakage current when 100 V was applied thereto was 3.38 × 10⁻⁶ A (electrode area = 0.0314 cm²).

(Preparation of transistor) A source electrode and a drain electrode (having a structure of having fullerene and gold stacked from a side of an organic semiconductor layer that will be described later, in this order) both with a channel length of 20 µm and a channel width of 2 mm were formed on a glass substrate with a vacuum deposition method with the use of a metal mask.

Subsequently, an application liquid was prepared by dissolving F8T2 (copolymer of 9,9-dioctyl fluorene: bithiophene = 50 : 50 (molar ratio); weight average molecular weight = 69,000 in terms of polystyrene) into chloroform which is a solvent to prepare a solution (organic semiconductor composition) with the concentration of 0.5 wt%, and then filtering the solution with a membrane filter. Then, the organic semiconductor layer with the thickness of approximately 60 nm was formed by applying the obtained application liquid onto the glass substrate so as to cover the above described source and drain electrodes, with a spin coating method.

Then, a gate insulating layer with the thickness of approximately 300 nm was formed by filtering the above described solution of the composition for an insulating layer with the use of a membrane filter with pores of 0.2 µm, applying the filtrate onto an organic semiconductor layer with a spin coating method, and curing the applied filtrate by heating the applied filtrate at 150°C for 90 minutes.

Then, by forming a gate electrode (having a structure of having fullerene and gold stacked from an organic semiconductor side in this order) on the gate insulating layer with a vacuum deposition method with the use of a metal mask, a top gate type of an electric-field effect type organic thin film transistor (transistor) was prepared.

(Evaluation for characteristics of transistor) The characteristics of the obtained transistor were measured by using a vacuum prober (BCT22MDC-5-HT-SCU made by Nagase Electronic Equipments Service Co. LTD) on conditions that a gate voltage Vg was changed to 0 to -60 V and a voltage Vsd between the source and the drain was changed to 0 to -60 V. In addition, the hysteresis was expressed by the absolute value of the voltage difference between a threshold voltage Vth₁ obtained when the voltage Vsd between the source and the drain was -50 V and the gate voltage Vg was changed from 0 V to -60 V and a threshold voltage Vth₂ obtained when the gate voltage Vg was changed from -60 V to 0 V. The obtained result is shown in Table 1.

**[Table 1]**

| Transistor | Example 1 |
|---|---|
| Threshold voltage (V) | -36 V |
| ON/OFF ratio | 5 × 10² |
| Hysteresis | 0.8 V |

### [Comparative Example 1]

### (Preparation of solution of composition for insulating layer)

A homogeneous application solution (solution of composition for insulating layer) was prepared by charging 1.00 g of polyvinyl phenol (made by Sigma-Aldrich Corporation, weight average molecular weight = 8,000 in terms of polystyrene), 0.194 g of a 1-butanol solution containing 84 wt% of a methylated product of poly(melamine-co-formaldehyde) (made by Sigma-Aldrich Corporation) and 7.00 g of 2-heptanone into a sample bottle with a capacity of 10 ml, and dissolving the compound while stirring the mixture.

(Preparation of transistor) A top gate type of an electric-field effect type organic thin film transistor was prepared in a similar way to that in Example 1 except that this solution of the composition for an insulating layer was used and a gate insulating layer was formed by heating the applied solution at 200°C for 1 hour.

The characteristics of the obtained transistor were measured by using a vacuum prober (BCT22MDC-5-HT-SCU made by Nagase Electronic Equipments Service Co. LTD.) on conditions that a gate voltage Vg was changed from 0 to -60 V and a voltage Vsd between the source and the drain was changed from 0 to -60 V However, this transistor could not work as a transistor.

It was confirmed from the above result that the transistor in Example 1 provided with a gate insulating layer which was formed from the composition for an insulating layer including the first and second compounds in combination could have an insulating layer which could be formed at a low temperature that does not produce the expansion and contraction of a plastic substrate, and had excellent withstand voltage.

### Reference Signs List

10, 20 ... Substrate, 12, 22 ... Source electrode, 14, 24 ... Drain electrode, 16, 26 ... Organic semiconductor layer, 18, 28 ... Gate insulating layer, 19, 29 ... Gate electrode, 30 ... Topcoat, 40 ... Organic EL device, 100, 200 ... Transistor, 300 ... Display.

## Claims

1. A composition for an insulating layer comprising:
a first compound formed of a polymer compound having two or more active hydrogen groups in the molecule; and
a second compound formed of a low-molecular compound having, in the molecule, two or more groups that produce a functional group that reacts with an active hydrogen group by electromagnetic radiations or heat.

2. The composition for an insulating layer according to claim 1, wherein the first compound is a polymer compound having at least one group selected from the group consisting of a phenolic hydroxyl group, an alcoholic hydroxyl group, an amino group, a mercapto group and a carboxyl group, as the active hydrogen group.

3. The composition for an insulating layer according to claim 1 or 2, wherein the first compound is a polyorganosilsesquioxane resin having an active hydrogen group.

4. The composition for an insulating layer according to any one of claims 1 to 3, wherein the first compound is a polyorganosilsesquioxane resin having at least one group selected from the group consisting of groups represented by the following formula (1) and groups represented by the following formula (2), as the active hydrogen group: 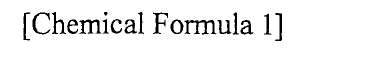 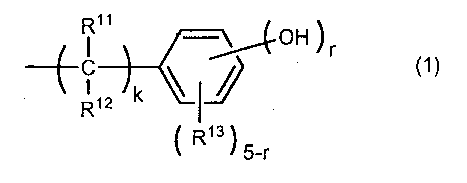 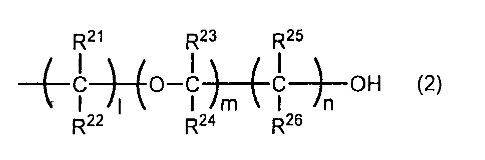 wherein R¹¹ and R¹² each independently represent a hydrogen atom or a monovalent organic group having 1 to 20 carbon atoms, R¹³ represents a hydrogen atom or a monovalent organic group having 1 to 20 carbon atoms, r is an integer of 1 to 5, and k is an integer of 0 or more, wherein when there are a plurality of R¹³, these may be the same or different; and R²¹, R²², R²³, R²⁴, R²⁵ and R²⁶ each independently represent a hydrogen atom or a monovalent organic group having 1 to 20 carbon atoms, 1 and m are each independently an integer of 0 or more, and n is an integer of 1 or more.

5. The composition for an insulating layer according to any one of claims 1 to 4, wherein the group that produces a functional group that reacts with an active hydrogen group by electromagnetic radiations or heat in the second compound is at least one group selected from the group consisting of a blocked isocyanato group and a blocked isothiocyanato group.

6. The composition for an insulating layer according to claim 5, wherein the blocked isocyanato group or the blocked isothiocyanato group is a group represented by the following formula (3a) or a group represented by the following formula (3b): 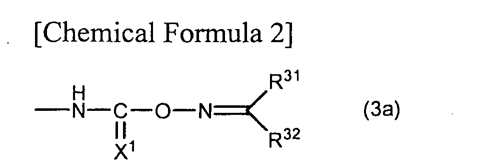 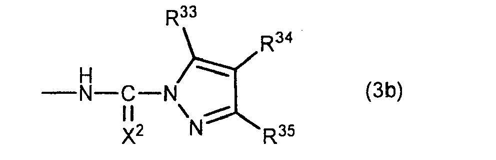 wherein X¹ and X² each independently represent an oxygen atom or a sulfur atom, and R³¹, R³², R³³, R³⁴ and R³⁵ each independently represent a hydrogen atom or a monovalent organic group having 1 to 20 carbon atoms.

7. The composition for an insulating layer according to any one of claims 1 to 6, wherein the second compound is at least one compound selected from the group consisting of compounds represented by the following formula (4a), and compounds represented by the following formula (4b): 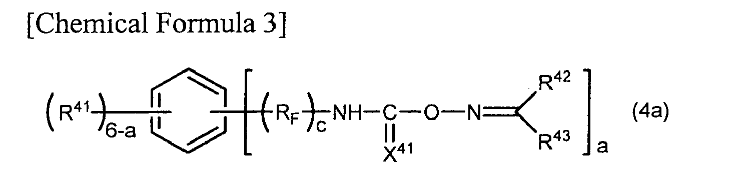 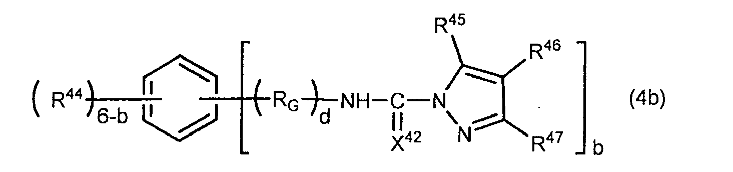 wherein X⁴¹ and X⁴² each independently represent an oxygen atom or a sulfur atom, and R⁴¹, R⁴², R⁴³, R⁴⁴, R⁴⁵, R⁴⁶ and R⁴⁷ each independently represent a hydrogen atom or a monovalent organic group having 1 to 20 carbon atoms, R_{F} and R_{G} each independently represent a divalent organic group having 1 to 20 carbon atoms, a and b are each independently an integer of 2 to 6, and c and d are each independently an integer of 0 to 20.
